# EUROPÄISCHE PATENTSCHRIFT

(11) **EP 0 751 611 B1**
(45) Veröffentlichungstag und Bekanntmachung des Hinweises auf die Patenterteilung: **03.03.1999**
(21) Anmeldenummer: 96810352.3
(22) Anmeldetag: 31.05.1996
(51) Int. Cl.: H02M 7/48, H02M 7/519

(54) **Stromrichterschaltungsanordnung**
Power converter circuit
Convertisseur de puissance

(30) Priorität: 26.06.1995 DE 19523096
(43) Veröffentlichungstag der Anmeldung: 02.01.1997
(73) Patentinhaber: ASEA BROWN BOVERI AG, 5400 Baden (CH)
(72) Erfinder: Grüning, Horst, Dr., 5430 Wettingen (CH)

(56) Entgegenhaltungen:
- US-A- 4 736 268
- PATENT ABSTRACTS OF JAPAN Bd. 010, Nr. 050 (E-384) 27 Februar 1986 & JP-A-60 203 016 (MEIDENSHA KK) 14 Oktober 1985
- LEISTUNGSELEKTRONIK Bd. 114, Nr. 21, Seiten 1310 - 1317 BÖSTERLIN, LUDWIG, SCHULZE UND TSCHARN 'Moderne Leistungshalbleiter in der Stromrichtertechnik'

## Beschreibung

### Technisches Gebiet

Die Erfindung bezieht sich auf das Gebiet der Leistungselektronik. Sie geht aus von einer Stromrichterschaltungsanordnung nach dem Oberbegriff des ersten Anspruchs.

### Stand der Technik

Ein solche Schaltungsanordnung ist wohl bekannt und wird beispielsweise im Artikel "Moderne Leistungshalbleiter in der Stromrichtertechnik", etz Bd. 114 (1993) Heft 21, Seiten 1310 bis 1319 beschrieben.

Diesen Schaltungsanordnungen ist gemeinsam, dass sie von einem Gleichspannungs- oder Gleichstromzwischenkreis gespeist werden und mindestens einen Zweig, bestehend aus einer Serieschaltung einer geraden Anzahl von Halbleiterschaltern umfassen. Der mittlere Knoten der Serieschaltung der Halbleiterschalter bildet einen Lastanschluss, an welchen eine Last, z.B. ein Motor angeschlossen werden kann.

Die Halbleiterschalter werden so ein- und ausgeschaltet, dass an der Last eine Wechselspannung mit z.B. einstellbarer Frequenz abgegeben wird. Die Halbleiterschalter müssen gegen zu steile Spannungs- und Stromflanken durch eine passive dV/dt- und dI/dt-Beschaltung geschützt werden. Diese Beschaltung umfasst beim Stand der Technik ein Netzwerk aus passiven Elementen wie Kondensatoren, Induktivitäten und Widerständen. Dieses Netzwerk ist teuer und benötigt viel Platz.

Um einen wirksame Beschaltung zu erreichen, wird in der Japanischen Offenlegungsschrift JP 60 203016 A vorgeschlagen, ein schaltbares Element in der Form eines Thyristors in die Beschaltung auszunehmen.

### Darstellung der Erfindung

Aufgabe der vorliegenden Erfindung ist es deshalb, eine Stromrichterschaltungsanordnung anzugeben, welche mit möglichst wenig Beschaltungselementen auskommt und deshalb weniger Platz benötigt und billig herzustellen ist.

Diese Aufgabe wird bei einer Schaltungsanordnung der eingangs genannten Art durch die Merkmale des ersten Anspruchs gelöst.

Kern der Erfindung ist es also, dass parallel zu den Halbleiterschaltern aktiv steuerbare Strom- und Spannungsanstiegsbegrenzungsmittel vorgesehen sind. Diese umfassen einen Bipolartransistor, der in Basisschaltung parallel zum Halbleiterschalter angeordnet ist. Somit ist die Basis des Bipolartransistors mit einer ersten, einer Kathode zugeordneten Hauptelektrode des Halbleiterschalters und der Kollektor mit einer zweiten, einer Anode zugeordneten Hauptelektrode des Halbleiterschalters verbunden. Zwischen Emitter und Basis ist zur Ansteuerung des Bipolartransistors eine Steuerschaltung vorgesehen. Diese steuert den Bipolartransistor so an, dass dieser einerseits, kurz bevor der Halbleiterschalter ausgeschaltet wird, für eine erste Zeitspanne eingeschaltet und andererseits bevor der Halbleiterschalter wieder eingeschaltet wird für eine zweite, länger als der Einschaltvorgang dauernde Zeitspanne eingeschaltet wird.

Auf diese Weise kann der Bipolartransistor beim Einschalten des Zweiges aktiv den Stromanstieg und die Spannungsflanke und beim Ausschalten die Steilheit der Spannungsflanke begrenzen. Da der Bipolartransistor also selektiv für beide Begrenzungsfunktionen eingesetzt werden kann, wird der Bauteilaufwand der Beschaltung geringer. Die Kosten und der Platzbedarf werden dadurch reduziert.

Weitere Ausführungsbeispiele ergeben sich aus den entsprechenden abhängigen Ansprüchen.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Eine Schaltungsanordnung eines dreiphasigen Wechselrichters mit einem Motor als Last;
- **Fig. 2**: Einen Halbleiterschalter mit einer Ersatzschaltung der parallel geschalteten Strom- und Spannunganstiegsbegrenzungsmitteln nach der Erfindung;
- **Fig. 3**: Zeitdiagramme für die Ansteuerung der erfindungsgemässen Strom- und Spannunganstiegsbegrenzungsmittel
- **Fig. 4**: Eine Schaltungsanordnung mit mehreren parallel geschalteten Halbleiterschaltern.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

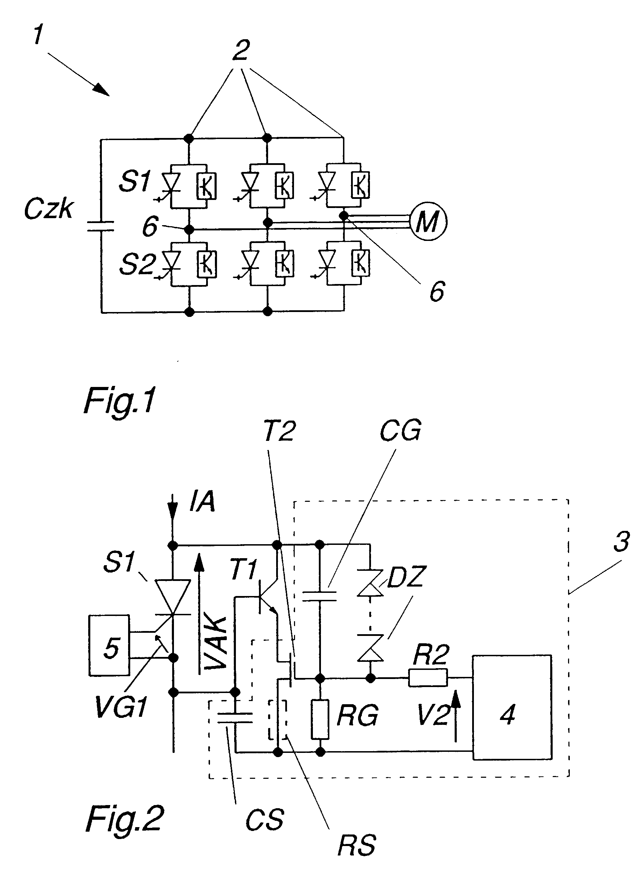

**Figur 1** zeigt das Ersatzschaltbild eines dreiphasigen Wechselrichters 1. Dieser ist z.B. Teil eines U-Umrichters zur Versorgung eines elektrischen Motors M. Ein derartiger U-Umrichter umfasst einen von einem Netz gespeisten Gleichrichter (nicht dargestellt), einen Gleichspannungszwischenkreis (dargestellt durch den Zwischenkreiskondensator Czk) und einen Wechselrichter mit der angeschlossen Last. Der Wechselrichter umfasst eine Anzahl Phasen oder Zweige 2, welche je aus einer Serieschaltung einer geraden Anzahl von Halbleiterschaltern bestehen. Dargestellt sind pro Zweig ein oberer Schalter S1 und ein unterer Schalter S2. Die Erfindung ist aber ausdrücklich nicht auf nur zwei Schalter beschränkt, sondern es können auch mehr als zwei Schalter pro Zweig vorgesehen werden. Der mittlere, gemeinsame Knoten der Serieschaltung bildet dabei einen Lastanschluss 6. Die Halbleiterschalter S1 und S2 der Anordnung werden nun nach bekannten Mustern mittels einer Ansteuerschaltung 5 ein- und ausgeschaltet, so dass an der Last eine mehrphasige Wechselspannung erzeugt wird. Diese Ansteuerungsverfahren sind wohl bekannt und bedürfen keiner weiteren Erläuterung.

Da es sich bei den Halbleiterschaltern S1 und S2 im allgemeinen um nicht rückwärtsleitende Bauelemente handelt, muss normalerweise parallel zum Halbleiterschalter eine Antiparalleldiode vorgesehen sein. Diese übernimmt nach der Kommutierung den Stromfluss. Die Halbleiterschalter, insbesondere auch GTOs, ertragen nur eine begrenzte Steilheit der Schaltflanken, so dass sie mit passiven Beschaltungskomponenten wie Stromanstiegsbegrenzungsdrosseln und Spannungsanstiegsbegrenzungkondensatoren geschützt werden müssen. Solche Beschaltungen umfassen eine Anzahl von Kondensatoren, Dioden, Induktivitäten und Widerständen, welche zusätzlich zur Antiparalleldiode vorgesehen werden müssen. Die Beschaltungen sind ebenfalls wohl bekannt und werden an dieser Stelle nicht weiter erläutert.

Nach der Erfindung werden nun parallel zu den Halbleiterschaltern S1 und S2 Strom- und Spannungsanstiegsbegrenzungsmittel vorgesehen. Diese Mittel sind so ausgebildet, dass sie gerade auch noch die Funktion der Antiparalleldiode übernehmen können. Dadurch kann ein Anzahl von Beschaltungselementen eingespart werden.

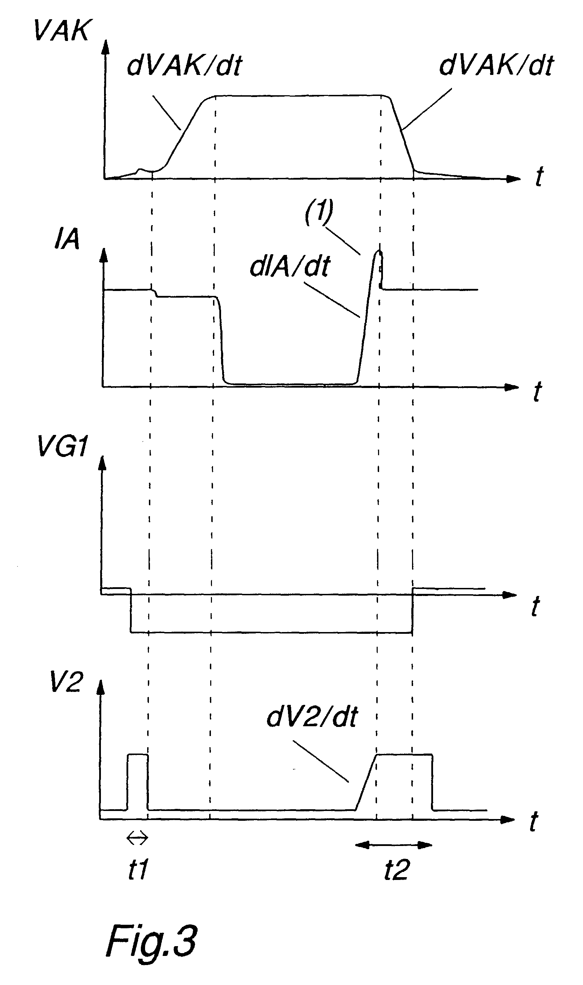

Die Strom- und Spannungsanstiegsbegrenzungsmittel umfassen einen Bipolartransistor T1, welcher in Basisschaltung parallel beispielsweise zum Halbleiterschalter S1 geschaltetet ist. Wie **Figur 2** zeigt, ist dabei die Basis des Bipolartransistor T1 mit der Kathode des GTO und der Kollektor mit der Anode des GTO verbunden. Ausserdem ist eine Steuerschaltung 3 vorgesehen, welche den Bipolartransistor T1 derart ansteuert, dass dieser kurz bevor der Halbleiterschalter S1 ausgeschaltet wird für eine erste Zeitspanne tl eingeschaltet wird. Die Steuerschaltung 3 ist so gestaltet, dass, wie weiter unten im Detail erläutert werden wird, eine aktive Begrenzung der Flankensteilheit der Spannung V_{AK} zwischen Anoden und Kathode des Halbleiterschalters S1 erreicht wird (siehe **Figur 3).**

Beim Einschalten des Halbleiterschalters S1 wird der Bipolartransistor T1 wiederum eingeschaltet und zwar für eine Zeitdauer t2, welche länger dauert als der Einschaltvorgang des Halbleiterschalters. Die Steuerspannung V2 steigt dabei linear an. Die Steuerschaltung 3 ist nun so ausgebildet, dass durch die Steuerung der Flankensteilheit der Spannung V2 die Stromsteilheit dI_{A}/dt durch den Halbleiterschalter S1 gesteuert werden kann.

Um die oben erläuterten Funktionen zu erfüllen, kann die Steuereinheit 3 wie in Figur 2 dargestellt aufgebaut sein. Die Schaltungsanordnung funktioniert wie folgt:

Kurz bevor der Halbleiterschalter S1 ausgeschaltet werden -soll - durch entsprechende Ansteuerung mittels der Ansteuereinheit 5, dargestellt durch die Gatespannung V_{G1} - wird der Bipolartransistor T1 durch Anlegen einer Spannung V2 an den MOSFET T2 eingeschaltet und übernimmt somit Strom. Dies ergibt einen kleinen Spannungsbuckel im Verlauf von V_{AK}. Die benötigte negative Spannung entnimmt T2 dabei dem Kondensator C_{S}. Dieser Kondensator umfasst vorzugsweise eine Parallelschaltung niederinduktiver Elektrolytkondensatoren.

Nach der Zeitspanne t2 - kurz nach dem Anlegen der negativen Gatespannung V_{G1} - wird V2 wieder auf Null gesteuert. Dadurch geht das Gate von T2 ebenfalls auf Null und T1 versucht wieder zu sperren, d.h. der Strom durch T2 nimmt ab. Dadurch erhöht sich aber die Spannung V_{AK} und ein Strom fliesst über C_{G}. Dieser Strom I_{CG} = (dV_{AK}/dt)*C_{G} führt zu einem Spannungsabfall in R_{G}. Damit ergibt sich wieder eine Spannung, welche den Transistor T2 ansteuert und damit T1 einschaltet. Diese Regelschleife erlaubt eine Regelung und Begrenzung des Spannungsanstieges dV_{AK}/dt. Der Grad der Begrenzung bzw. die Steilheit der Spannungsflanke wird dabei im wesentlichen durch die "Zeitkonstante" C_{G}*(R_{G}∥R₂) bestimmt.

Beim Einschalten des Halbleiterschalters S1 läuft folgender Vorgang ab:

Bevor das Vorzeichen der Gatespannung V_{G1} verändert wird, wird T2 mit einer linear ansteigenden Spannung angesteuert. Dies ergibt eine Stromgegenkopplung über den Widerstand R_{S}. Dadurch nimmt der Drainstrom von T2 zu und somit auch I_{A}, denn der Bipolartransistor ist ja in Basisschaltung geschaltet und "verstärkt" diesen Strom um den Faktor "1". Auf diese Weise kann die Steilheit dI_{A}/dt des Stromes I_{A} über die Spannungssteilheit dV₂/dt eingestellt werden.

Mit dem Einschalten des betrachteten Halbleiterschalters S1 wird der entsprechende, stromleitende Schalter S2 desselben Zweiges ausgeschaltet. Dadurch ergibt sich ein "Reverse Recovery" des Schalters S2. Dies äussert sich in einem Überschwingen des Stromes I_{A}, in Figur 3 mit (1) bezeichnet. Sobald diese Reverse Recovery abgeschlossen ist, nimmt der Schalter S2 Spannung auf und dadurch erniedrigt sich V_{AK}. Die Spannung V2 wird nun festgehalten und es läuft derselbe Regelvorgang wie beim Ausschalten ab, so dass die Spannungsflankensteilheit dV_{AK}/dt im wesentlichen durch die "Zeitkonstante" C_{G}*(R_{G}∥R₂) bestimmt wird. Sobald die Spannung V_{AK} gegen Null gegangen ist, wird das Vorzeichen der Gatespannung V_{G1} umgekehrt, wodurch Halbleiterschalter S1 voll leitend wird und den Strom übernimmt. Anschliessend kann auch die Steuerspannung V₂ nach Ablauf der Zeitspanne t2 weggenommen werden.

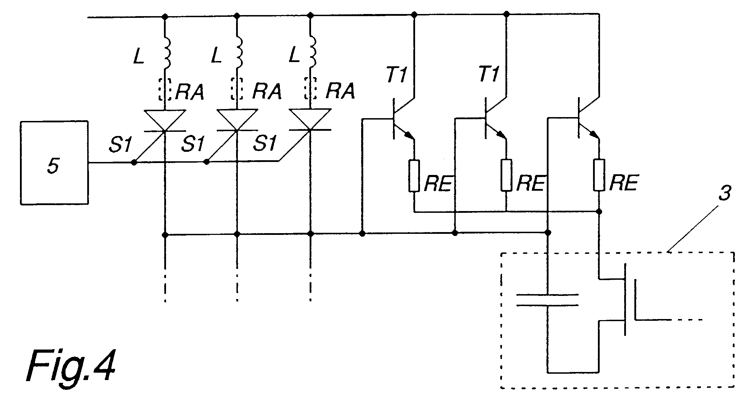

Die Zenerdioden D_{Z} dienen der Spannungsbegrenzung und sind parallel zu C_{G} geschaltet. Der Bipolartransistor T1 kann in ähnlicher Technologie wie der GTO ausgeführt sein. Vorzugsweise wird er so hergestellt, dass seine Basis in direktem Druckkontakt mit der dem Kollektor gegenüberliegenden Druckkontaktplatte eines z.B. runden Leistungshalbleiterdruckkontaktgehäuses kommt. Die Emitteranschlüsse werden seitlich herausgeführt. In den Emitterzuführungen können auch Gegenkopplungswiderstände R_{E} vorgesehen werden. Dadurch kann die Stromaufteilung unter den einzelnen Emittersegmenten wirksam ausgeglichen werden. Diese Widerstände werden so dimensioniert, dass bei Nennstrom etwa 0.3 bis 3 V abfallen. Dies ist vor allem für die Parallelschaltung mehrerer Halbleiterschalter S1 bzw. S2 pro Zweig von Vorteil (siehe Figur 4). Der Bipolartransistor wird vorzugsweise in ein niederinduktives Gehäuse, wie es in der EP-A2-0 588 026 beschrieben wird, eingebaut. Als GTO wird vorzugsweise ein Bauteil verwendet, wie es in der o.g. Schrift offenbart wird.

Die erfindungsgemässe Schaltungsanordnung ermöglicht ausserdem die direkte Parallelschaltung der Halbleiterschalter S1 bzw. S2. Die Halbleiterschalter S1, S2 werden dabei von einer gemeinsamen Ansteuereinheit 5 angesteuert. Dasselbe gilt für die Steuereinheit 3 der Bipolartransistoren T1, welche nur einmal vorgesehen ist. Den Anoden der Halbleiterschalter S1, S2 können noch kleine Induktivitäten L und Widerstände R_{A} vorgeschaltet werden, so dass der Strom in den einzelnen Halbleiterschaltern während unterschiedlichen Abschaltverzögerungen aufgrund einer Exemplarsteuerung im wesentlichen konstant bleibt.

Die Erfindung ist auf keinen Fall auf den in Figur 1 dargestellten Wechselrichter beschränkt, sondern kann in allen leistungselektronischen Schaltungsanordnungen eingesetzt werden. So z.B. auch in dem dem Gleichspannungszwischenkreis vorgeschalteten Gleichrichter oder in Umrich tern mit Gleichstromzwischenkreis mit einer beliebigen Anzahl von Phasen. Insgesamt erlaubt die Erfindung den Bau von Schaltungsanordnungen, welche mit wenigen Beschaltungselementen auskommen.

### Bezeichnungsliste

- 1: Stromrichterschaltungsanordnung
- 2: Zweig, Phase
- 3: Lastanschluss
- 4: Steuereinheit
- 5: Ansteuereinheit
- 6: Lastanschluss
- S1, S2: Halbleiterschalter
- T1: Bipolartransistor
- T2: Steuertransistor
- C_{S}, C_{G}: Kondensatoren
- R_{S}, R_{G},: Widerstände
- R₂, R_{E}: Widerstände
- R_{A}: Widerstand
- D_{Z}: Zenerdioden
- V_{G1}: Gatespannung
- V_{AK}: Anoden-Kathoden-Spannung
- V₂: Steuerspannung
- I_{A}: Strom
- L: Induktivität

## Patentansprüche

1. Stromrichterschaltungsanordnung (1) mit mindestens einem an einen Zwischenkreis angeschlossenen Zweig (2), wobei der oder jeder Zweig (2) mindestens zwei Halbleiterschalter (S1, S2), insbesondere von GTOs, umfasst, sowie mit mindestens einem Lastanschluss (6), welcher durch den mittleren Knoten der Serieschaltung von Halbleiterschaltern (S1, S2) des oder jedes Zweiges (2) gebildet wird, wobei parallel zu den Halbleiterschaltern (S1, S2) aktiv steuerbare Strom- und Spannungsanstiegsbegrenzungsmittel vorgesehen sind, dadurch gekennzeichnet, dass die aktiv steuerbare Strom- und Spannungsanstiegsbegrenzungsmittel einen Bipolartransistor (T1) und eine Steuerschaltung (3) umfassen, wobei die Basis des Bipolartransistors (T1) mit einer ersten, einer Kathode zugeordneten Hauptelektrode der Halbleiterschalter (S1, S2) und dessen Kollektor mit einer zweiten, einer Anode zugeordneten Hauptelektrode der Halbleiterschalter (S1, S2) verbunden ist und wobei der Bipolartransistor (T1) von der Steuerschaltung (3), welche im wesentlichen zwischen Emitter und Basis angeordnet ist, angesteuert wird.

2. Schaltungsanordnung nach Anspruch 1, dadurch gekennzeichnet, dass die Steuerschaltung (3) einen Steuertransistor (T2), insbesondere in Form eines MOSFET, einen ersten Kondensator (C_{S}), einen zweiten Kondensator (C_{G}), einen ersten und einen zweiten Widerstand (R_{G} und R₂) sowie eine steuerbare Spannungsquelle (V₂) umfasst, wobei der erste Kondensator (C_{S}) über den Steuertransistor (T2) zwischen Basis und Emitter des Bipolartransistors (T1) geschaltet ist, die Spannungsquelle (V₂) über den zweiten Widerstand (R₂) mit der Steuerelektrode des Steuertransistors (T2) verbunden ist, zwischen der Steuerelektrode und einer ersten Hauptelektrode des Steuertransistors (T2) der erste Widerstand (R_{G}) angeordnet ist und der zweite Kondensator (C_{G}) zwischen den Kollektor des Bipolartransistors (T1) und der Steuerelektrode des Steuertransistors (T2) geschaltet ist.

3. Schaltungsanordnung nach Anspruch 2, dadurch gekennzeichnet, dass zwischen dem Steuertransistor (T2) und dem ersten Kondensator (C_{S}) ein dritter Widerstand (R_{S}) vorgesehen ist.

4. Schaltungsanordnung nach Anspruch 2 oder 3, dadurch gekennzeichnet, dass die Steuerschaltung (3) so ausgebildet ist, dass der Bipolartransistor (T1) einerseits, kurz bevor die Halbleiterschalter (S1, S2) ausgeschaltet werden, für eine erste Zeitspanne (t1) eingeschaltet und andererseits bevor die Halbleiterschalter (S1, S2) wieder eingeschaltet werden für eine zweite, länger als der Einschaltvorgang dauernde Zeitspanne (t2) eingeschaltet wird.

5. Verfahren zur Ansteuerung der Steuerschaltung einer schaltungsanordnung nach Anspruch 2, dadurch gekennzeichnet, dass der Bipolartransistor (T1) einerseits, kurz bevor die Halbleiterschalter (S1, S2) ausgeschaltet werden, für eine erste Zeitspanne (t1) eingeschaltet und andererseits bevor die Halbleiterschalter (S1, S2) wieder eingeschaltet werden für eine zweite, länger als der Einschaltvorgang dauernde Zeitspanne (t2) eingeschaltet wird.

6. Verfahren nach Anspruch 5, dadurch gekennzeichnet, dass das Einschalten des Steuertransistors (T2) vor dem erneuten Einschalten der Halbleiterschalter (S1 oder S2) mit einer endlichen Flankensteilheit erfolgt, durch welche der Stromanstieg in den Halbleiterschaltern (S1 bzw. S2) bestimmt wird.

## Claims

1. Converter circuit arrangement (1) having at least one branch (2) connected to an intermediate circuit, the or each branch (2) comprising at least two semiconductor switches (S1, S2), in particular GTOs, and also having at least one load terminal (6) which is formed by the central node of the series circuit of semiconductor switches (S1, S2) of the or of each branch (2), actively controllable current and voltage rise limiting means being provided in parallel with the semiconductor switches (S1, S2), characterized in that the actively controllable current and voltage rise limiting means comprise a bipolar transistor (T1) and a control circuit (3), the base of the bipolar transistor (T1) being connected to a first main electrode, assigned to a cathode, of the semiconductor switches (S1, S2), and the collector of said bipolar transistor (T1) being connected to a second main electrode, assigned to an anode, of the semiconductor switches (S1, S2), and the bipolar transistor (T1) being driven by the control circuit (3), which is arranged essentially between the emitter and the base.

2. Circuit arrangement according to Claim 1, characterized in that the control circuit (3) comprises a control transistor (T2), in particular in the form of an MOSFET, a first capacitor (C_{S}), a second capacitor (C_{G}), a first and a second resistor (R_{G} and R₂) and also a controllable voltage source (V₂), the first capacitor (C_{S}) being connected via the control transistor (T2) between the base and emitter of the bipolar transistor (T1), the voltage source (V₂) being connected via the second resistor (R₂) to the control electrode of the control transistor (T2), the first resistor (R_{G}) being arranged between the control electrode and a first main electrode of the control transistor (T2), and the second capacitor (C_{G}) being connected between the collector of the bipolar transistor (T1) and the control electrode of the control transistor (T2).

3. Circuit arrangement according to Claim 2, characterized in that a third resistor (R_{S}) is provided between the control transistor (T2) and the first capacitor (C_{S}).

4. Circuit arrangement according to Claim 2 or 3, characterized in that the control circuit (3) is designed in such a way that the bipolar transistor (T1) is turned on, on the one hand, shortly before the semiconductor switches (S1, S2) are turned off, for a first time interval (t1) and is turned on, on the other hand, before the semiconductor switches (S1, S2) are turned on again, for a second time interval (t2) which lasts longer than the turn-on operation.

5. Method for driving the control circuit of a circuit arrangement according to Claim 2, characterized in that the bipolar transistor (T1) is turned on, on the one hand, shortly before the semiconductor switches (S1, S2) are turned off, for a first time interval (t1) and is turned on, on the other hand, before the semiconductor switches (S1, S2) are turned on again, for a second time interval (t2) which lasts longer than the turn-on operation.

6. Method according to Claim 5, characterized in that the control transistor (T2) is turned on before the renewed turning on of the semiconductor switches (S1 or S2), with a finite slope gradient, by which the current rise in the semiconductor switches (S1 or S2) is determined.

## Revendications

1. Convertisseur de puissance (1) avec au moins une branche (2) raccordée à un circuit intermédiaire, la ou les branches (2) comprenant au moins deux commutateurs à semiconducteur (S1, S2), notamment des GTO, et avec au moins une borne de charge (6), laquelle est formée par le noeud central du circuit série des commutateurs à semiconducteur (S1, S2) de la ou des branches (2), des moyens de limitation de l'augmentation du courant et de la tension commandables de manière active étant prévus en parallèle avec les commutateurs à semiconducteur (S1, S2), caractérisé par le fait que les moyens de limitation de l'augmentation du courant et de la tension commandables de manière active comprennent un transistor bipolaire (T1) et un module de commande (3), la base du transistor bipolaire (T1) étant reliée à une première électrode princpale des commutateurs à semiconducteur (S1, S2) associée à une cathode et son collecteur étant relié à une deuxième électrode principale des commutateurs à semiconducteur (S1, S2), associée à une anode, et le transistor bipolaire (T1) étant commandé par le circuit de commande (3) qui est essentiellement disposé entre l'émetteur et la base.

2. Arrangement de circuit selon la revendication 1, caractérisé par le fait que le circuit de commande (3) comprend un transistor de commande (T2), notamment sous la forme d'un MOSFET, un premier condensateur (C_{S}), un deuxième condensateur (C_{G}), une première et une deuxième résistances (R_{G} et R₂) ainsi qu'une source de tension (V₂) commandable, le deuxième condensateur (C_{S}) étant branché entre la base et l'émetteur du transistor bipolaire (T1) par le biais du transistor de commande (T2), la source de tension (V₂) étant reliée à l'électrode de commande du transistor de commande (T2) par le biais de la deuxième résistance (R₂), la première résistance (R_{G}) étant disposée entre l'électrode de commande et une première électrode principale du transistor de command (T2) et le deuxième condensateur (C_{G}) étant branché entre le collecteur du transistor bipolaire (T1) et l'électrode de commande du transistor de commande (T2).

3. Arrangement de circuit selon la revendication 2, caractérisé par le fait qu'une troisième résistance (R_{S}) est prévue entre le transistor de commande (T2) et le premier condensateur (C_{S}).

4. Arrangement de circuit selon la revendication 2 ou 3, caractérisé par le fait que le circuit de commande (3) est réalisé de telle manière que le transistor bipolaire (T1) soit, d'une part, activé pendant un premier intervalle de temps (t1) juste avant l'ouverture des commutateurs à semiconducteur (S1, S2) et, d'autre part, activé pendant un deuxième intervalle de temps (t2), plus long que la durée du processus de fermeture, avant la fermeture des commutateurs à semiconducteur (S1, S2)

5. Méthode de commande du circuit de commande d'un arrangement de circuit selon la revendication 2, caractérisée par le fait que le transistor bipolaire (T1) est, d'une part, activé pendant un premier intervalle de temps (t1) juste avant l'ouverture des commutateurs à semiconducteur (S1, S2) et, d'autre part, activé pendant un deuxième intervalle de temps (t2), plus long que la durée du processus de fermeture, avant la fermeture des commutateurs à semiconducteur (S1, S2).

6. Méthode selon la revendication 5, caractérisée par le fait que l'activation du transistor de commande (T2) avant la refermeture des commutateurs à semiconducteur (S1 ou S2) a lieu avec une raideur de front donnée qui est déterminée par l'augmentation du courant dans les commutateurs à semiconducteur (S1 ou S2).
